# EUROPÄISCHE PATENTSCHRIFT

(11) **EP 1 665 593 B1**
(45) Veröffentlichungstag und Bekanntmachung des Hinweises auf die Patenterteilung: **20.01.2010**
(21) Anmeldenummer: 04738139.7
(22) Anmeldetag: 11.08.2004
(51) Int. Cl.: H04H 60/04

(54) **SCHIEBEREGLER FÜR EIN TON-MISCHPULT**
SLIDE CONTROL FOR AN AUDIO MIXER
REGLAGE A CURSEURS POUR UNE CONSOLE DE MIXAGE DU SON

(30) Priorität: 21.08.2003 CH 142803
(43) Veröffentlichungstag der Anmeldung: 07.06.2006
(73) Patentinhaber: Studer Professional Audio GmbH, 8105 Regensdorf (CH)
(72) Erfinder: HUBER, Robert, CH-8103 Unterengstringen (CH)
(74) Vertreter: Bertsch, Florian Oliver
(86) Internationale Anmeldenummer: PCT/CH2004/000500
(87) Internationale Veröffentlichungsnummer: WO 2005/020485

(56) Entgegenhaltungen:
- WO-A-98/28760
- DE-A- 3 322 414
- DE-A- 3 411 302
- US-A- 4 130 080
- US-B1- 6 438 241

## Beschreibung

Die Erfindung betrifft ein Ton-Mischpult mit einem Schieberegler, bei dem ein Schieber längs einem begrenzten Weg in einer schlitzförmigen Öffnung in einer Frontplatte verschoben werden kann.

In modernen digital arbeitenden Mischpulten für Tonsignale ist es üblich, dass ein einziger Schieberegler mehrere Funktionen oder Parameter beeinflussen oder einstellen kann. Einem solchen Schieberegler ist deshalb mindestens eine Wähltaste oder ein gleichwertiges Element zugeordnet, mit dem die gewünschte Funktion oder der gewünschte Parameter angewählt werden kann. Ist dies geschehen, so kann der Schieberegler von Hand oder durch Motorantrieb in eine gewünschte.Stellung verschoben werden, wobei die gewünschte Wirkung eintritt. Oft stellt sich aber das Problem, dass die Bedienperson auch nach einer gewissen Zeit noch wissen sollte, welche Funktion oder welchen Parameter der angewählte Schieberegler gerade beeinflusst. Dazu ist es bekannt, in einer Taste, mit der der Schieberegler in bekannter Weise beispielsweise von Hand betätigt wird, eine Anzeige einzubauen. Diese kann darin bestehen, dass in der Taste ein Beleuchtungselement untergebracht ist und die Taste aus durchscheinendem oder durchsichtigem Material besteht. So soll die Taste verschiedenfarbig leuchten, je nach der Funktion die sie gerade ausübt oder beeinflusst. Ist das Mischpult mit einem Bildschirm ausgerüstet, so kann in diesem ebenfalls eine Anzeige gemacht werden, die angibt, welche Funktion oder welchen Parameter der angewählte Schieberegler gerade beeinflusst.

Diese bekannten Lösungen weisen den Nachteil auf, dass die Beleuchtung der Tasten der Schieberegler konstruktiv aufwendig ist und in der Produktion teuer zu stehen kommt. Dies weil die Speisung für die Beleuchtung im beweglichen Teil des Schiebereglers sichergestellt werden muss. Zudem hat sich bei der Benützung in der Praxis gezeigt, dass die Beleuchtung der Tasten oft zu schwach ist oder nicht genügend auffällt, da die Tasten von der Frontplatte vorstehen und auch von anderen Lichtquellen beleuchtet werden können. Wird die angewählte Funktion auf einem Bildschirm angezeigt, so ist dieser meist mehr oder weniger weit vom betreffenden Schieberegler entfernt, so dass das Auge der Bedienperson immer hin- und her wandern muss. Man muss bedenken, dass moderne Mischpulte auch bei mehrfacher Belegung Dutzende Schieberegler aufweisen und deshalb eine Verwechslung sehr leicht möglich ist. US 4 130 080 offenbart eine Anzeigestruktur für einen Mikrowellenofen, bei der ein Handgriff vorgesehen ist. Bei Verschieben des Handgriffs wird durch Beleuchtung der Frontplatte sichtbar, welche Einstellung gewählt wurde.

Es ist deshalb eine Aufgabe der Erfindung, wie sie in den Patentansprüchen gekennzeichnet ist, ein solchens Tonmischpult zu schaffen, das die genannten Nachteile nicht aufweist und das klar anzeigt, welche Funktion es ausübt oder welchen Parameter es durch seine Stellung beeinflussen kann.

Dies geschieht erfindungsgemäss dadurch, dass längs neben oder vorzugsweise in der schlitzförmigen Öffnung, in der ein Schieber mit einer Taste längs einem begrenzten Weg in der Frontplatte verschoben werden kann, ein beleuchtbares Element vorgesehen ist, das parallel zur Öffnung verläuft. Das beleuchtbare Element erscheint bei der Aufsicht auf die Frontplatte als leuchtender länglicher Streifen, der parallel zur Bahn des Schiebers verläuft. Der leuchtende Streifen kann sowohl kontinuierlich sein oder in Abschnitte unterteilt werden. Das beleuchtbare Element besteht aus einem Lichtleiter und einer Lichtquelle, die vorzugsweise mehrfarbiges Licht aussenden kann. Als Lichtquelle ist vorzugsweise eine Mehrfarbenleuchtdiode vorgesehen. Das beleuchtbare Element ist über einen Lichtleiter und eine Lichtquelle mit einer Wähltaste oder einem Wähltastenfeld verbunden, mit dem die gewünschte Funktion oder der gesuchte Parameter angewählt werden kann. Die Wähltaste zum Auswählen mindestens einer Funktion ist so mit der Lichtquelle für das beleuchtbare Element verbunden, dass diese so angesteuert wird, dass der betreffenden Funktion oder dem betreffenden Parameter eine bestimmte Farbe für das Licht aus der Lichtquelle zugeordnet ist. Es kann für jede Funktion je eine Wähltaste und für jede Funktion eine eigene Farbe für das Licht aus dem beleuchtbaren Element vorgesehen sein.

Die durch die Erfindung erreichten Vorteile sind insbesondere darin zu sehen, dass es damit der Bedienperson des Mischpultes viel leichter möglich ist, klar zu erkennen, welcher Funktion ein bestimmter Schieberegler gerade zugeschaltet ist oder welchen Parameter er bei der vorliegenden Stellung der Tasten im Wähltastenfeld gerade beeinflussen kann. Durch die vorgesehene Art der Beleuchtung ist es leichter möglich auch bei hellem Umgebungslicht die Farbe des leuchtenden Streifens im Schieberegler richtig wahrzunehmen. Da die Taste oder der Knopf des Schiebereglers, der mit der Hand der Bedienperson verschoben werden soll, einen Teil des leuchtenden Streifens abdeckt, erkennt die Bedienperson auch leicht, in welcher Stellung sich die Taste oder der Knopf längs der Öffnung gerade befindet. Somit wird die Arbeit mit mehreren Schiebereglem, die je mehrere Funktionen ausüben oder mehrere Parameter beeinflussen können, sehr stark erleichtert, so dass auch weniger Fehlbedienungen zu erwarten sind.

Im folgenden wird die Erfindung anhand eines Ausführungsbeispiels und Figuren näher erläutert. Es zeigt:
- Fig. 1: eine Aufsicht auf einen Teil eines Tonmischpultes mit mehreren Schiebereglern,
- Fig. 2: einen Schnitt durch einen Schieberegler längs einer Linie A-A in Fig. 1 und
- Fig. 3: eine Ansicht eines erfindungsgemässen Schiebereglers.

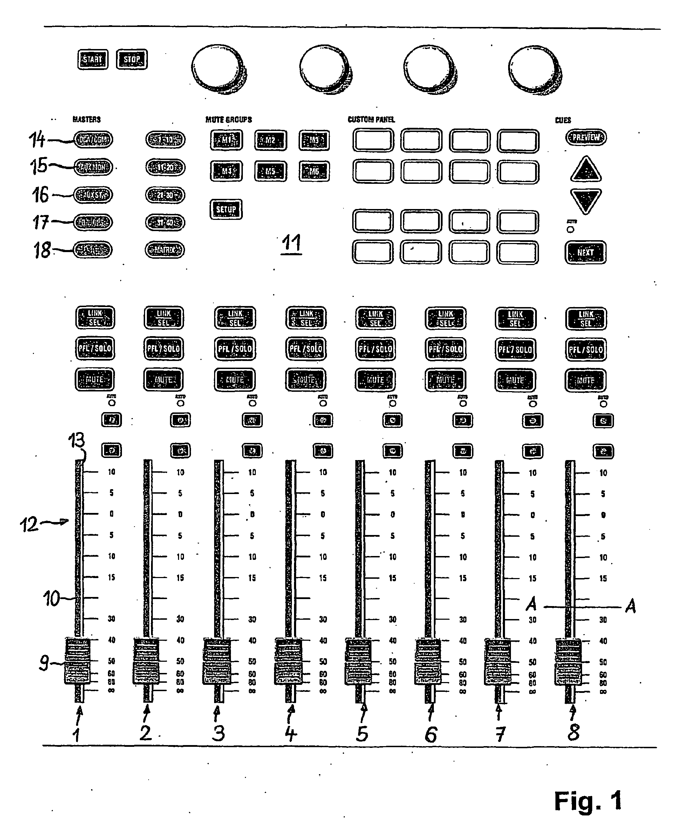

Fig. 1 zeigt eine Aufsicht auf einen Teil eines Tonmischpultes mit mehreren Schiebereglern 1 bis 8. Ein Schieber 9, der hier einen Knopf oder eine Taste aufweist, kann in einer schlitzförmigen Öffnung 10 in einer Frontplatte 11 eines Ton-Mischpultes längs einem, durch die Länge der Öffnung begrenzten, Weg 12 verschoben werden. In oder unmittelbar neben der Öffnung 10 ist ein beleuchtbares Element 13 vorgesehen, das von oben erkennbar ist und als länglicher Streifen erscheint. Neben anderen Tasten, die hier nicht näher bezeichnet sind, erkennt man insbesondere fünf Wähltasten 14 bis 18, wobei jede Wähltaste 14 bis 18 dazu vorgesehen ist, mindestens einen der Schieberegler 1 bis 8 einer Funktion zuzuordnen, die auf eines oder mehrere Tonsignale ausgeübt wird, oder mindestens einen Parameter zu beeinflussen oder einzustellen, der bei der Verarbeitung eines oder mehrerer Tonsignale wichtig ist.

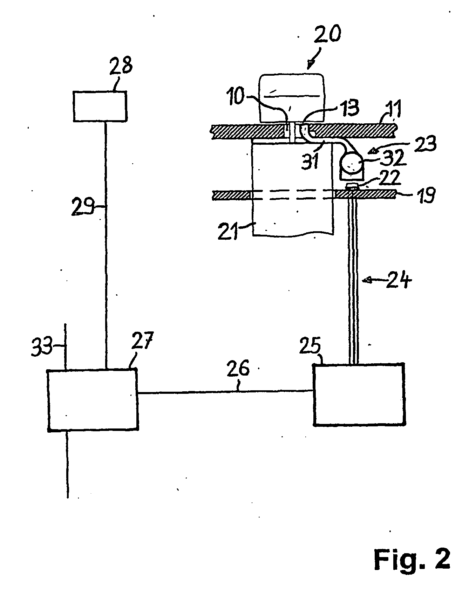

Fig. 2 zeigt einen Schnitt durch einen Teil eines Ton-Mischpultes mit einem Schieberegler, wobei man eine Frontplatte 11, eine Leiterplatte 19, einen Schieber 20, ein mit dem Schieber 20 verbundenes und dadurch betätigtes Stellelement 21, das beispielsweise als Potentiometer ausgebildet sein kann, eine Lichtquelle 22 und einen Lichtleiter 23 erkennt. Die Lichtquelle 22 sei hier eine Mehrfarbenleuchtdiode und ist auf der Leiterplatte 19 angeordnet. Sie ist über Leitungen 24 mit einem Digital/Analog-Wandler 25 verbunden. Dieser ist wiederum über eine Leitung 26 mit einem Prozessor 27 verbunden, der wiederum an mindestens eine Wähltaste 28 über eine Leitung 29 angeschlossen ist. In der Frontplatte 11 erkennt man auch die Öffnung 10 mit dem beleuchteten Streifen 13. Der Lichtleiter 23 ist vorzugsweise an der Frontplatte 11 angeordnet, könnte aber auch auf der Leiterplatte 19 befestigt sein.

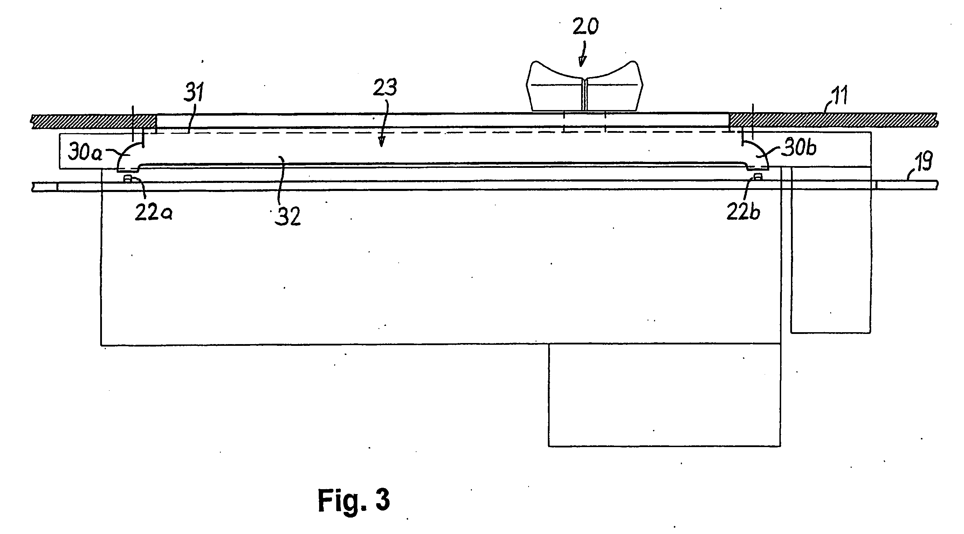

Fig. 3 zeigt die bereits aus der Figur 2 bekannten Elemente wie insbesondere den Schieber 20, den Lichtleiter 23 und die Öffnung 10 in Seitenansicht. Man erkennt auch, dass vorzugsweise zwei Lichtquellen 22a und 22b vorgesehen sind, wobei jede an einem Ende des Lichtleiters 23 angeordnet ist. Der Lichtleiter 23 weist deshalb auch an beiden Enden je einen gebogenen Lichtschacht 30a und 30b auf, dessen Aufgabe es ist, das Licht aus den Lichtquellen 22a und 22b in eine Richtung umzulenken, die parallel zur Öffnung 10 liegt.

Die Wirkungsweise der Erfindung ist wie folgt:
Wenn man mit einer Wähltaste 14 bis 18 (Fig. 1) oder 28 (Fig. 2) eine Funktion oder einen Parameter anwählt, für die beispielsweise der Schieberegler 1 zur Wirkung gelangen soll, so wird dies dem Prozessor 27 über die Leitung 29 gemeldet. Dieser Prozessor 27 kann diese Funktion wie beispielsweise eine Filterung eine Mischung usw. auf ein Tonsignal aus einer Leitung 33 ausüben und gleichzeitig über die Leitung 26 den Digital/Analog-Wandler 25 ansteuern, der über die Leitungen 24 die Lichtquelle 22 oder die Lichtquellen 22a und 22b so einschaltet, dass diese Licht mit der gewünschten Farbe abstrahlen. So kann eine solche Lichtquelle 22 oder auch beide Lichtquellen 22a, 22b Licht in der fest vorgegebenen Farbe abstrahlen oder, aus den beispielsweise drei Farben, die sie abstrahlen kann eine gewünschte weitere Farbe durch Mischung aus den drei Farben erzeugen. Immer gelangt das Licht über den oder die gebogenen Lichtschächte 30a, 30b in den Lichtleiter 23 oder dessen Hauptteil 32, der so ausgebildet ist, dass er das Licht möglichst gleichmässig in Längsrichtung verteilt. Das kann durch geeignete Beschichtung oder andere Massnahmen geschehen. Der Lichtleiter 23 kann hohl oder ausgefüllt sein oder auch aus einem Bündel lichtleitender Fasern bestehen. Jedenfalls soll das Licht auf der ganzen Länge der Öffnung 10 in diese austreten, was durch eine streifenförmige Endfläche sichergestellt wird, die neben der Bewegungsbahn des Schiebers 9, 20 angeordnet ist und das beleuchtbare Element 13 bildet. Die streifenförmige Endfläche oder das beleuchtbare Element 13 ist über einen mehrfach gebogenen Leiter 31, wie er aus der Fig. 2 besonders gut ersichtlich ist, mit dem Hauptteil 32 des Lichtleiters 23 verbunden. So kann die Verteilung des Lichts in Längsrichtung in einem geeigneten Abstand von der Öffnung 10 im Hauptteil 32 erfolgen. Das Licht tritt dann seitlich aus dem Hauptteil 32 in den mehrfach gebogenen Leiter 31 über, der in das streifenförmige, beleuchtbare Element 13 mündet. In entsprechender Weise kann durch Betätigen einer anderen Wähltaste die Farbe des beleuchtbaren Elementes 13 im Schieberegler 1 ausgeschaltet oder verändert werden. Dies hängt davon ab, wie dieser Schieberegler 1 durch die betreffende Wähltaste für seine Aufgabe im Mischpult eingesetzt wird.

## Patentansprüche

1. Ton-Mischpult mit einem Schieberegler, bei dem ein Schieber (9, 20) längs einem begrenzten Weg (12) in einer schlitzförmigen Öffnung (10) in einer Frontplatte (11) verschoben werden kann, wobei ein beleuchtbares Element (13) vorgesehen ist, das längs der Öffnung verläuft, wobei das beleuchtbare Element mit einem Lichtleiter (23, 30, 31) verbunden und an eine Lichtquelle (22) angeschlossen ist,
**dadurch gekennzeichnet,**
**dass** die Lichtquelle mehrfarbiges Licht aussenden kann, wobei das beleuchtbare Element über einen Lichtleiter (23) und eine Lichtquelle (22) mit einer Wähltaste (14-18, 28) verbunden ist, die Wähltaste zum Auswählen mindestens einer Funktion vorgesehen ist und wobei die Lichtquelle so angesteuert ist, dass der betreffenden Funktion eine bestimmte Farbe für das Licht aus der Lichtquelle zugeordnet ist.

2. Ton-Mischpult nach Anspruch 1,
**dadurch gekennzeichnet,**
**dass** das beleuchtbare Element bei Aufsicht auf die Frontplatte als leuchtender länglicher Streifen erscheint.

3. Ton-Mischpult nach Anspruch 1,
**dadurch gekennzeichnet,**
**dass** als Lichtquelle eine Leuchtdiode vorgesehen ist.

4. Ton-Mischpult nach Anspruch 1,
**dadurch gekennzeichnet,**
**dass** der Lichtleiter an der Frontplatte (11) angeordnet ist.

5. Ton-Mischpult nach Anspruch 1,
**dadurch gekennzeichnet,**
**dass** die Lichtquelle auf einer Leiterplatte (19) angeordnet ist.

6. Ton-Mischpult nach Anspruch 1,
**dadurch gekennzeichnet,**
**dass** je eine Wähltaste für je eine Funktion vorgesehen ist und dass für jede Funktion eine eigene Farbe für das Licht aus dem beleuchtbaren Element vorgesehen ist.

7. Ton-Mischpult nach Anspruch 1,
**dadurch gekennzeichnet,**
**dass** das beleuchtbare Element in der Öffnung vorgesehen ist.

## Claims

1. Audio mixer with a slide control, in which a slider (9, 20) can be shifted along a limited path (12) in a slot-shaped opening (10) in a face plate (11), wherein an illuminable element (13) is provided which extends along the opening, wherein the illuminable element is coupled to a light guide (23, 30, 31) and connected to a light source (22),
**characterized in that**
the light source is capable of emitting multi-colored light, wherein the illuminable element is coupled to a selector key (14-18, 28) via a light guide (23) and a light source (22), the selector key being provided for selecting at least one function, and wherein the light source is controlled such that a predetermined color of the light from the light source is assigned to the respective function.

2. Audio mixer according to claim 1,
**characterized in that**
the illuminable element is appearing as a luminous elongated strip in a top view of the face plate.

3. Audio mixer according to claim 1,
**characterized in that**
a light emitting diode is provided as a light source.

4. Audio mixer according to claim 1,
**characterized in that**
the light guide is arranged on the face plate (11).

5. Audio mixer according to claim 1,
**characterized in that**
the light source is arranged on a circuit board (19).

6. Audio mixer according to claim 1,
**characterized in that**
one selector key is provided for each function, and that an own color of the light from the illuminable element is provided for each function.

7. Audio mixer according to claim 1,
**characterized in that** the illuminable element is provided in the opening.

## Revendications

1. Console de mixage de son comprenant un régulateur à coulisse, dans lequel un curseur (9, 20) peut être déplacé le long d'un trajet délimité (12) dans un orifice en forme de fente (10) dans une face avant (11), un élément éclairable (13) étant prévu s'étendant le long de l'orifice, l'élément éclairable étant relié à un conduit de lumière (23, 30, 31) et étant connecté à une source de lumière (22),
**caractérisée en ce que** la source de lumière peut émettre une lumière multicolore, l'élément éclairable étant relié à une touche de sélection (14-18, 28) à travers un conduit de lumière (23) et une source de lumière (22), la touche de sélection étant prévue pour sélectionner au moins une fonction, et la source de lumière étant adressée de telle manière qu'une couleur déterminée de la lumière venant de la source de lumière est associée à la fonction concernée.

2. Console de mixage de son selon la revendication 1, **caractérisée en ce qu'**en vue de dessus sur la face avant, l'élément éclairable apparaît sous forme de bande allongée lumineuse.

3. Console de mixage de son selon la revendication 1, **caractérisée en ce qu'**on prévoit une diode électroluminescente en tant que source de lumière.

4. Console de mixage de son selon la revendication 1, **caractérisée en ce que** le conduit de lumière est disposé sur la face avant (11).

5. Console de mixage de son selon la revendication 1, **caractérisée en ce que** la source de lumière est disposée sur une carte de circuit imprimé (19).

6. Console de mixage de son selon la revendication 1, **caractérisée en ce que** pour chaque fonction, on prévoit une touche de sélection respective, et pour chaque fonction, on prévoit une couleur propre pour la lumière venant de l'élément éclairable.

7. Console de mixage de son selon la revendication 1, **caractérisée en ce que** l'élément éclairable est prévu dans l'orifice.
